Europäisches Patentamt

(19) European Patent Office

Office européen des brevets

(11) Numéro de publication: **0 429 345 A1**

(12) **DEMANDE DE BREVET EUROPEEN**

(21) Numéro de dépôt: 90403242.2

(51) Int. Cl.5: **C04B 35/58, C23C 14/24**

(22) Date de dépôt: **16.11.90**

(30) Priorité: **20.11.89 GB 8926164**

(43) Date de publication de la demande:
**29.05.91 Bulletin 91/22**

(84) Etats contractants désignés:
**AT BE CH DE DK ES FR GB GR IT LI LU NL SE**

(71) Demandeur: **BORIDE CERAMICS & COMPOSITES LIMITED**
**Cox Lane**
**Chessington, Surrey KT9 1SJ(GB)**

(72) Inventeur: **Creffield, Geoffrey Kenneth**
**83, Rhodrons Avenue**
**Chessington, Surrey KT9 1AY(GB)**
Inventeur: **Thompson, Raymond**
**7, Winchester Close**
**Esher, Surrey KT10 8QH(GB)**
Inventeur: **Woodfield, Mostyn W.**
**7, Cherry Walk**
**Monmouth, Gwent, 1 Wales MP5 4DE(GB)**

(74) Mandataire: **Dubruc, Philippe et al**
**RHONE-POULENC CHIMIE Service Brevets**
**Chimie 25, quai Paul-Doumer**
**F-92408 Courbevoie Cédex(FR)**

(54) **Procédé pour la préparation d'articles composites refractaires.**

(57) L'invention concerne une composition utilisable pour la préparation de nacelles d'évaporation de l'aluminium pour la métallisation sous vide.

Cette composition est caractérisée en ce qu'elle comprend de 30 à 70% en poids de diborure de titane et de nitrure d'aluminium pour chacun respectivement, le pourcentage total en poids étant d'au moins 85%, un ou plusieurs additifs de frittage de ces éléments et du nitrure de bore.

L'invention concerne aussi les objets frittés obtenus à partir de cette composition.

## PROCEDE POUR LA PREPARATION D'ARTICLES COMPOSITES REFRACTAIRES

La présente invention concerne des procédés de préparation d'articles composites céramiques ou intermétalliques utilisés pour contenir et évaporer l'aluminium et d'autres métaux pour la métallisation sous vide et des techniques apparentées.

On connaît peu de matériaux qui sont résistants du point de vue chimique pour contenir de l'aluminium fondu à des températures au voisinage de 1500° C. Lorsqu'il est contenu dans une enceinte sous vide à ces températures, l'aluminium peut être évaporé doucement et peut être déposé sur des surfaces plus froides dans le voisinage. L'enrobage continu d'une feuille plastique par une couche mince d'aluminium, selon ce procédé, constitue une partie importante de l'industrie de l'emballage et on prépare de la même manière un film métallisé pour les activités électroniques et apparentées.

Les matériaux généralement préférés pour l'utilisation dans la fabrication de ce que l'on appelle les nacelles ou creusets d'évaporation sont le diborure de titane plus le nitrure d'aluminium et le nitrure de bore, seuls ou en mélange. Chacun de ces matériaux résiste à l'attaque de l'aluminium à 1500° C pendant plusieurs heures dans le vide ou sous atmosphère inerte.

Les hautes températures nécessaires pour l'évaporation du métal à partir de ces nacelles sont habituellement obtenues par chauffage direct résistif par application d'un courant électrique. Comme le diborure de titane est un bon conducteur de l'électricité, avec une conductivité semblable à celle du fer, et que les nitrures d'aluminium et de bore sont tous les deux des isolants électriques, un mélange de ces matériaux est utilisé pour fabriquer de telles nacelles qui peuvent être chauffées par résistance. En fonction des rapports entre les matériaux utilisés et du degré de compactage ou de densification, on peut obtenir des résistivités dans le domaine désiré de 125 à 1200 micro-ohm cm. La fabrication ou la mise en forme se fait par une technique de métallurgie de poudre à partir de particules fines ; aucune autre route n'étant possible car le diborure de titane fond au-dessus de 3000° C et les deux nitrures se subliment ou se décomposent sans fondre.

Une méthode connue pour la fabrication de ces nacelles consiste à compacter ou presser le mélange de poudre dans des matrices en graphite vers 2000° C et avec des pressions uniaxialles d'environ 276 bars (4000 lb/in²). Ce procédé est connu sous le nom de pressage à chaud. A l'exception du diborure de titane submicronique quand il est pressé seul, aucun de ces matériaux s'il est pressé séparément ou dans un mélange quelconque n'est connu corne pouvant fritter de lui-même. Afin d'obtenir un degré de densification équivalent à 90% ou plus de la densité théorique, il est nécessaire d'appliquer de la chaleur et de la pression simultanément ; il s'agit évidemment d'une opération coûteuse.

Pour que le procédé de pressage à chaud soit viable économiquement il est nécessaire de former de grandes brames et de les couper ensuite aux taille et forme appropriées et dans le nombre de nacelles requis. La dureté du diborure de titane et du nitrure d'aluminium sont telles que des outils en diamant sont nécessaires pour cette opération qui est aussi facilitée par la présence habituelle d'une proportion relativement élevée (environ 25%) de nitrure de bore. De telles opérations d'usinage sont coûteuses en temps, en énergie et en perte de matière tels que les poussières et les copeaux durant la mise en forme.

Les nacelles pour cette utilisation qui sont chauffées par résistance ont normalement une forme rectangulaire. Les dimensions varient d'environ 7,62 cm à 25,4 cm en longueur, avec une largeur et une profondeur d'environ 3,175 à 0,635 cm. Une cavité s'étendant sur la plus grande partie de la longueur de la nacelle est usinée sur un ou deux côtés opposés.

Il a été considéré depuis longtemps qu'il était préférable de couler, mouler, presser ou de matricer le mélange de poudre directement dans la forme des produits finis individuels selon des techniques établies de fabrication des céramiques. De tels procédés comprennent le pressage de poudre et le pressage isostatique à froid d'un mélange de poudre. Ils sont suivis par un frittage des objets formés à haute température pour obtenir un produit dur et étanche. Cette technique n a pas été utilisée jusqu'à présent aux mélanges de diborure de titane, de nitrure d'aluminium et de nitrure de bore à cause de l'impossibilité mentionnée plus haut pour ces matériaux à fritter sans l'application d'une pression.

Il a été trouvé qu'en choisissant des combinaisons particulières de diborure de titane, de nitrure d'aluminium et de nitrure de bore, en présence d'un ou plusieurs additifs de frittage, la fabrication de nacelles sous forme pratiquement finie est possible par des techniques telles que le pressage isostatique et l'extrusion suivie d'un frittage (sans pression).

En conséquence, la présente invention fournit une composition qui convient pour la fabrication de composites utilisables dans la métallisation sous vide et dans des techniques apparentées, comprenant de 30 à 70% en poids de diborure de titane et de nitrure d'aluminium pour chacun respectivement, le pourcentage total en poids étant d'au moins 85, un ou plusieurs additifs de frittage de ces éléments et du nitrure de bore. La présente invention fournit aussi un procédé de fabrication d'un objet fritté à partir d'une telle composition qui comprend le compactage ou pressage de la composition sous forme de poudre et le frittage de la composition pressée à une température de 1300 à 2100°C. Le pourcentage total en poids de diborure de titane et de nitrure d'aluminium est d'au moins 85 c'est-à-dire que l'additif de frittage et les autres constituants, y compris le nitrure de bore, constituent au maximum 15% en poids. Le rapport en poids du diborure de titane au nitrure d'aluminium est de 3:7 à 7:3, plus particulièrement d'environ 4:6 à 6:4 et, en particulier d'environ 4:5, le pourcentage en poids de nitrure de bore s'élève jusqu'à 10, et le pourcentage en poids de l'additif de frittage s'élève jusqu'à 5, généralement de 1 à 5.

L'additif de frittage aide au frittage des particules de nitrure d'aluminium les unes aux autres et à celles du diborure de titane. Par un choix judicieux des additifs de frittage, ou en utilisant une combinaison de tels additifs, les particules de diborure de titane peuvent aussi frittées les unes avec les autres.

De tels additifs de frittage pour le nitrure d'aluminium sont bien connus et comprennent en particulier les oxydes d'alcalino-terreux et de terres rares, en particulier l'oxyde de cérium et l'oxyde d'yttrium. Le mécanisme de leur action consiste à former une phase vitreuse par réaction avec la surface des particules de nitrure d'aluminium qui portent un film mince d'oxyde d'aluminium. Alternativement ou d'une manière additionnelle, on a montré que certains métaux, généralement des groupes IV à VIII de la classification périodique des éléments sous forme élémentaire en poudre aident au frittage du nitrure d'aluminium. Par exemple, l'inclusion d'une poudre de nickel permet d'obtenir en 30 mn à 1100°C des densités supérieures à 90% de la densité théorique, alors que le nitrure d'aluminium ne fritte pas seul quelle que soit la température. Dans certains cas, cependant, l'utilisation de tels métaux peut être nuisible car leur présence dans le composite peut entraîner une réaction avec l'aluminium fondu. Au contraire, il est possible d'utiliser différents borures et carbures tels que le borure de chrome, le carbure de chrome, le borure de tungstène, le carbure de molybdène, le diborure ou hexaborure d'yttrium ou d'autres borures de terres rares ou d'alcalino-terreux tel qu'un borure de lanthane ou un borure de calcium, ou du carbure de tungstène qui est préféré.

On peut fritter sans pression à partir de 1500°C une poudre de diborure de titane si elle est de taille de particules submicroniques. Des particules plus grossières fritteront aussi naturellement mais pas à une densité aussi élevée. Quand on augmente les températures, on augmente aussi les degrés obtenus de frittage et de retrait, mais il subsiste une structure poreuse. Le diborure de titane peut former un borure ternaire par réaction avec la plupart des métaux de la classification périodique, mais plus particulièrement avec ceux des groupes IV à VIII. Les métaux du groupe du fer, qui comprend le cobalt et le nickel, réagissent facilement de cette manière et en conséquence une petite proportion de ceux-ci ajoutée au diborure de titane agira comme un additif de frittage quand on chauffera à une température suffisamment élevée.

C'est donc selon une variante préférée de l'invention que l'additif de frittage aide à la fois au frittage du nitrure d'aluminium et du diborure de titane, et se comporte ainsi effectivement de la même manière vis-à-vis des deux. Spécifiquement la composition contiendra 0,5 à 2% d'oxyde de terres rares et 1 à 3% de métal ou de carbure ou borure de métal. Des agents réducteurs tels que l'hydrure de calcium et du noir de carbone peuvent aussi augmenter le frittage.

Bien que du nitrure de bore soit présent dans la composition, on préfère qu'au moins environ 2% de nitrure de bore soient présents puisque celui-ci facilite l'usinabilité du composite résultant et sa résistance aux chocs thermiques. La quantité préférée de nitrure de bore est de 2 à 10% en poids.

La structure des particules des constituants principaux de ces nacelles d'évaporation intermétallique est à plaquettes hexagonales ce qui conduit à la formation d'un objet anisotrope quand il est fabriqué par pressage uniaxial conventionnel. Ceci a pour inconvénient que les nacelles ont tendance à se déliter à l'usage alors que l'anisotropie de la caractéristique de résistance électrique peut signifier que le découpage d'une brame pressée uniaxiallement ne peut pas être optimisé.

Un autre avantage de la présente invention réside ainsi dans le fait que la formation de nacelles individuelles par pressage isostatique à froid donne des objets qui après frittage sont réellement isotropique en ce qui concerne toutes les propriétés physiques.

Selon une caractéristique de l'invention, un liant est inclus dans le mélange de poudre grâce à quoi les poudres mélangées peuvent être mises sous forme d'une pâte qui est ensuite extrudée sous forme d'une tige rectangulaire ayant comme section transversale celle de la nacelle désirée. Une telle tige a une résistance accrue suffisante pour permettre à la nacelle d'être coupée à la longueur désirée et pour permettre d'y usiner la cavité contenant le métal avant que la nacelle soit transférée dans un four pour la pyrolyse du liant avant le chauffage à la température de frittage complet.

L'utilisation de tels liants est bien connue ; des liants convenables sont l'alcool polyvinylique, les cires et les colloïdes protecteurs. La quantité de liant nécessaire dépendra de sa nature. Pour les colloïdes protecteurs des quantités de 0,1 à 2% en poids par rapport au poids total de la composition conviennent généralement. Des exemples de colloïdes protecteurs sont des colloïdes protecteurs contenant des liaisons ether telle que la methylcellulose, la carboxymethylcellulose, l'hydroxymethylcellulose, l'hydroxyéthyl- cellulose, l'ethylhydroxyethylcellulose, la methylcellulose, ou le polyvinylbutyral plastifié avec un ester phtalate.

Selon un mode de réalisation spécifique, les constituants sous forme de poudre, en particulier avec une surface spécifique de 3 à 7 $m^2/g$ sont broyés ensemble dans un broyeur à boulets avec un liant dans un liquide inerte tel que l'heptane pendant, par exemple, 2,5 heures. Le mélange est ensuite granulé et le liquide évaporé, généralement sous agitation mécanique. De préférence après un tamisage, par exemple à travers un tamis de 200 μm, le mélange granulé est transféré dans la matrice d'une presse à froid ou dans le sac d'une presse isostatique à froid. Le pressage à froid a alors lieu ; généralement le pressage en matrice est réalisé à une pression de 50 à 400 MPa, plus particulièrement environ 200 MPa, alors que le pressage isostatique est réalisé à une pression de 100 à 400 MPa, plus particulièrement environ 190 MPa. Si nécessaire, les composites crus résultant peuvent être usinés à la forme désirée. Le liant doit alors être éliminé par chauffage sous azote, par exemple, pendant plusieurs heures, par exemple 6. Le composite peut alors être fritté. Au démarrage le frittage peut être réalisé sous vide pour éliminer tous les gaz qui se dégagent après quoi une surpression d'azote peut être appliquée pour faciliter le retrait de frittage de l'objet. Le frittage peut être conduit tout d'abord à une température faible, par exemple, de 1300 à 1500°C pendant quelques heures et ensuite à une température plus élevée, par exemple, de 1800 à 2100°C sur une durée semblable. Les meilleurs résultats ont été obtenus en utilisant une température d'environ 1400°C et d'environ 2000°C respectivement. Un cycle de frittage spécifique est le suivant :
- 20°C à 1400°C en trois heures,
- palier à 1400°C pendant une demi-heure,
- 1400°C à 2000°C en 1-2 heures,
- palier à 2000°C pendant trois heures.

En alternative au frittage sans pression, des nacelles préparées selon l'invention peuvent être frittées à de hautes densités par pressage à chaud isostatique connu sous le nom de HIP. Ce procédé nécessite d'encapsuler chaque nacelle individuellement avec une couche étanche de verre ou une feuille de métal afin que le frittage se produise à la température du frittage sous une surpression d'azote. Comme autre alternative et moins coûteuse, le procédé connu sous le nom de frittage HIP peut être aussi utilisé. Celui-ci repose sur la fusion de la composition de la nacelle à la surface pour fournir de manière autonome la couche étanche nécessaire.

De même, la présente invention concerne aussi un objet fritté, ayant de préférence une densité d'au moins 90% de la densité théorique, obtenue à partir de la composition de la présente invention. En particulier, l'objet fritté comprend les mêmes éléments que ceux de la composition de la présente invention dans les mêmes proportions à l'exception du liant, avec notamment les additifs de frittage ou les produits de réaction de ceux-ci résultant du frittage. Ainsi, tout ce qui a été dit plus haut concernant la nature et les proportions des éléments constitutifs de la composition s'applique de même ici pour la définition de la constitution de l'objet ou du corps fritté.

L'invention est par ailleurs illustrée par les exemples qui suivent.

Exemple 1

Une poudre de diborure de titane (450 g) de taille moyenne de particules de 4 à 6 um est mélangée avec une poudre de nitrure de bore (25 g) et un mélange de nitrure d'aluminium submicronique (400 g) auquel a été ajouté de l'oxyde de calcium (20 g). Le mélange résultant est mis en suspension avec une solution à 1% de méthylcellulose dissoute dans l'éthanol, broyé dans un broyeur à boulets pendant trente minutes puis on fait évaporer l'alcool. La masse obtenue est tamisée à travers un tamis de 250 μm avant d'être pressée uniaxialement dans une matrice métallique rectangulaire à une pression de 390 MPa. La barrette est placée dans un four sous atmosphère d'azote et on augmente lentement la température pour éliminer le matériau organique pyrolysé avant de la monter à 1750°C et de la maintenir pendant deux heures.

Après refroidissement la barrette se trouve avoir rétréci et présente une densité mesurée de 93% de la densité théorique. Elle s'est avérée être facilement usinable par le diamant.

Exemple 2

Du diborure de titane, du nitrure d'aluminium et du nitrure de bore dans les mêmes proportions que celles de l'exemple 1 sont broyés de la même manière avec de l'oxyde d'yttrium (25 g) de taille de particules inférieure à 0,5 μm à la place de l'oxyde de calcium. Le mélange séché est introduit dans un sac façonné en caoutchouc silicone d'une presse isostatique à froid et compacté à une densité de 74% de la densité théorique. Après un traitement thermique similaire la barrette se trouve avoir rétréci d'une manière uniforme et présente une densité mesurée de 94% de la densité théorique.

Exemple 3

Du diborure de titane (400 g) et du nitrure d'aluminium (450 g) sont mélangés avec du nitrure de bore (20 g) et une poudre submicronique de nickel (20 g). Le mélange est mis en suspension avec une solution aqueuse de carboxymethylcellulose, broyé dans un broyeur à boulets pendant trente minutes et ensuite séché par atomisation. Le produit est compacté en utilisant une presse isostatique à froid code dans l'exemple 2 et on suit un cycle de chauffage semblable. Le retrait se révèle légèrement supérieur et le produit plus dur et plus conducteur électriquement à cause de la plus grande coalescence des particules de diborure de titane. La densité du produit est de 94% de la densité théorique.

Exemple 4

Du diborure de titane (400 g), du nitrure d'aluminium (500 g) et du nitrure de bore (20 g) sont mis en suspension dans de l'alcool anhydre contenant 1% de methylcellulose et dans lequel a été dispersée une suspension de nitrate de nickel anhydre (15 g). Après broyage dans le broyeur à boulets, on fait évaporer l'alcool et la masse est traitée comme dans l'exemple 1. Le frittage a lieu à 1550° C pendant 90 mn. Après refroidissement un objet semblable en dureté et conductivité est obtenu avec une densité de 95% de la densité théorique.

Exemple 5

La composition et le procédé de mélange de l'exemple 3 sont utilisés de nouveau excepté que l'on pétrit les poudres en une pâte rigide avec du polyvinylbutyral et de l'ethylphtalate avant de les extruder à la main à travers une filière de section carrée. On fait sécher la barre résultante, on l'ébarbe légèrement et on la fritte dans le même four.

Le produit s'avère être légèrement moins dense (91%).

Exemple 6

Du diborure de titane (375 g) et du nitrure d'aluminium (450 g) sont mélangés avec de l'oxyde de magnésium (22,5 g) et du noir de carbone (10 g). Le mélange est broyé à sec au broyeur à boulets pendant une heure avant d'être pressé à froid à 25 tonnes/in$^{-2}$ comme dans l'exemple 1. L'objet compacté est soigneusement chargé dans un four de frittage et chauffé à 1750° C pendant deux heures dans une atmosphère d'argon après évacuation des oxydes de carbone.

Le produit est similaire à celui de l'exemple 1 mais sa résistivité est quelque peu plus élevée.

Exemple 7

Du diborure de titane (500 g) est mélangé avec du nitrure d'aluminium (400 g), du nitrure de bore (40 g) et de l'oxyde de calcium (10 g). Le mélange sec est soigneusement ajouté à une dispersion d'hydrure de calcium (10 g) dans de l'éthanol anhydre et légèrement broyé pendant trente minutes dans un broyeur à boulets à évent. Après évaporation de l'éthanol la poudre désagrégée est traitée comme dans l'exemple 1, avec soin pour éviter l'apparition de moisissures avant de placer l'objet compacté dans le four.

Le produit final fritté est plus dur et légèrement plus dense (93%). Il est mouillé facilement par l'aluminium fondu.

Exemple 8

On refait l'exemple 3 excepté qu'une poudre submicronique de mousse de fer est utilisée à la place du nickel. On obtient des produits frittés similaires. La densité est de 94 % de la densité théorique.

Exemple 9

Afin d'évaluer les effets combinés d'un oxyde additif de frittage pour le nitrure d'aluminium et d'un métal pour le diborure de titane, à 500 g de chacun des principaux constituants en mélange sont ajoutés une poudre de nickel (25 g) et de l'oxyde de cérium submicronique (25 g). Le mélange est ensuite traité et fritté code dans l'exemple 3.

Après avoir été maintenue à 1700° C pendant quatre vingt dix minutes la barrette refroidie se trouve avoir une densité de 96% de la densité théorique et être mouillée facilement dans l'aluminium.

Exemple 10

Du borure de titane (400 g), du nitrure d'aluminium (500 g) et du nitrure de bore (70 g) plus des poudres d'oxyde d'yttrium (10 g) et de nickel (20 g) plus 4,0% d'un liant (à base d'une cire et contenant de l'acide oléique agissant comme lubrifiant) sont mélangés dans un broyeur à boulets dans de l'heptane (2,5 heures). Le solvant est éliminé par évaporation tout en agitant mécaniquement le mélange. Le mélange granulaire sec est tamisé à travers un tamis de 200 μm et transféré dans la matrice d'une presse à froid.

Le mélange est pressé à température ambiante sous une pression de 200 MPa. On élimine la cire du composite pressé par chauffage à 550°C sous atmosphère d'azote pendant six heures.

La densité du produit densifié cru se révèle être de 2,08 g/cm³ (équivalent à 57,7% de la densité théorique). Le produit densifié cru est transféré dans un four où il est chauffé sous azote selon les conditions suivantes :
- 20°C à 1400°C en trois heures
- palier à 1400°C pendant une demi-heure
- 1400 à 2000°C en deux heures
- palier à 2000°C pendant trois heures

Après refroidissement la densité du produit fritté se révèle être 3,34 g/cm³ (équivalent à 93% de la densité théorique).

Exemple 11

On suit la procédure décrit dans l'exemple 10, excepté que l'on utilise une poudre de carbure de tungstène (20 g) à la place du nickel. Le pressage en matrice est effectué à 150 MPa, la densité accrue est de 2,03 g/cm³ (56,1% de la densité théorique). On utilise les mêmes conditions de frittage ce qui donne un produit fritté de densité de 3,42 g/cm³ (95% de la densité théorique).

Exemple 12

Un mélange de diborure de titane (400 g), de nitrure d'aluminium (500 g), de nitrure de bore (70 g), d'oxyde d'yttrium (10 g) et de carbure de tungstène (20 g) est broyé dans un broyeur à boulets avec une cire à titre de liant dans l'heptane pendant 2,5 heures. L'élimination du solvant suivie d'une granulation de laboratoire se fait de la même manière que celle décrite dans l'exemple 10.

Le produit pressé est ensuite transféré dans un four de frittage chauffé à 2000°C dans les conditions décrites dans l'exemple

Après refroidissement le composite fritté a une densité de 3,42 g/cm³ (équivalent à 95% de la densité théorique).

Exemple 13

Un mélange de poudres consistant en du diborure de titane (400 g), du nitrure d'aluminium (500 g), du nitrure de bore (70 g), de l'oxyde d'yttrium (10 g), du nickel (20 g) plus 66 g d'un liant sous forme de cire est préparé comme dans l'exemple 10. Il est pressé isostatiquement à froid à 190 MPa comme décrit dans l'exemple 12. Cette étape est suivie d'une élimination de la cire (élimination du liant) code décrit ci-dessus.

Le composite cru (densité 2,01 g/cm³ équivalent à 55,7% de la densité théorique) est placé dans un creuset en graphite et immergé dans une poudre de nitrure d'aluminium. Il est fritté dans une atmosphère d'argon à 1900°C. Après avoir été enlevé du four le composite fritté s'est relevé avoir une densité de 3,42 g/cm³ équivalent à 91 % de la densité théorique.

## Revendications

1. Composition caractérisée en ce qu'elle comprend de 30 à 70% en poids de diborure de titane et de nitrure d'aluminium pour chacun respectivement, le pourcentage total en poids étant d'au moins 85%, un ou plusieurs additifs de frittage de ces éléments et du nitrure de bore.

2. Composition selon la revendication 1 caractérisée en ce qu'elle contient jusqu'à 10% du poids total du nitrure de bore.

3. Composition selon l'une des revendications 1 ou 2 caractérisée en ce que se trouve présent à titre d'additif de frittage jusqu'à 5% en poids d'un oxyde d'alcalino-terreux ou de terres rares.

4. Composition selon la revendication 3, caractérisée en ce que l'oxyde est l'oxyde de cérium ou l'oxyde d'yttrium.

5. Composition selon l'une quelconque des revendications 1 à 4 caractérisée en ce qu'est présent à titre d'additif de frittage jusqu'à 5% en poids d'un métal des groupes IV à VIII de la classification périodique des éléments.

6. Composition selon l'une quelconque des revendications 1 à 4 caractérisée en ce qu'elle comprend à titre d'additif de frittage jusqu'à 5% en poids d'un borure ou d'un carbure.

7. Composition selon la revendication 6, caractérisée en ce que l'additif de frittage est le carbure de tungstène.

8. Composition selon l'une quelconque des revendications 4 à 7, caractérisée en ce qu'elle contient un oxyde du type défini dans la revendication 3 et un carbure ou un borure.

9. Composition selon l'une quelconque des revendications précédentes, caractérisée en ce qu'elle contient aussi de l'hydrure de calcium.

10. Composition selon l'une quelconque des revendications précédentes, caractérisée en ce qu'elle comprend aussi un liant.

11. Procédé de préparation d'un objet fritté à partir d'une composition selon l'une quelconque des revendications précédentes caractérisé en ce qu'il comprend le compactage de la composition sous forme de poudre et le frittage de la composition compactée à une température de 1300 à 2100°C.

12. Procédé selon la revendication 11 caractérisé en ce qu'on effectue le frittage sans appliquer de pression mécanique.

13. Procédé selon la revendication 11 ou 12 caractérisé en ce que le compactage est réalisé par pressage isostatique à froid.

14. Procédé selon la revendication 11 ou 12 caractérisé en ce que le compactage est réalisé par extrusion mécanique.

15. Procédé selon l'une quelconque des revendications 11 à 14, caractérisé en ce qu'on effectue un frittage préalable sous vide pour éliminer tous les gaz dégagés et en ce qu'on applique ensuite une surpression d'azote.

16. Procédé selon l'une quelconque des revendications 11 à 15, caractérisé en ce que l'objet fritté est sous forme de creuset.

17. Objet fritté obtenu à partir d'une composition selon l'une quelconque des revendications 1 à 10.

18. Objet fritté caractérisé en ce qu'il comprend de 30 à 70% en poids de diborure de titane et de nitrure d'aluminium pour chacun respectivement, le pourcentage total en poids étant d'au moins 85, un ou plusieurs additifs de frittage de ces éléments et du nitrure de bore.

19. Objet fritté selon la revendication 17 ou 18, caractérisé en ce qu'il a une densité qui est d'au moins 90% de la densité théorique.

20. Objet fritté selon l'une des revendications 18 ou 19 caractérisé en ce qu'il comprend un ou plusieurs additifs de frittage choisis dans le groupe comprenant les oxydes d'alcalino-terreux ou de terres rares, les métaux des groupes IV à VIII de la classification périodique des éléments, les borures et les carbures.

21. Objet fritté selon l'une quelconque des revendications 18 à 20 caractérisé en ce qu'il comprend du nitrure de bore jusqu'à 10% du poids total.

22. Objet fritté selon l'une quelconque des revendications 18 à 21 caractérisé en ce qu'il comprend un ou plusieurs additifs de frittage jusqu'à 5% en poids.

23. Objet fritté selon l'une quelconque des revendications 17 à 22 caractérisé en ce qu'il se présente sous forme d'un creuset.

24. Procédé pour la métallisation sous vide d'un film plastique utilisant un creuset obtenu par un procédé selon l'une des revendications 11 à 16 ou du type selon la revendication 23.

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| X | GB-A-2 132 227  (UNION CARBIDE CORP.)<br>* Revendications 1,3-8; page 1, lignes 44-47 * | 1-3,5, 17-24 | C 04 B  35/58<br>C 23 C  14/24 |
| Y | | 8,11-13 ,16 | |
| X | GB-A-1 160 755  (ELEKTROSCHMELZWERK KEMPTEN GmbH)<br>* Revendications 1-4,9,10; exemple 1; page 1, lignes 62-68; page 2, lignes 31-44 * | 1,2,6,7 ,17-24 | |
| Y | | 8 | |
| Y | GB-A-1 097 000  (REYNOLDS METALS CO.)<br>* Exemple 2 * | 11-13, 16 | |
| X | US-A-4 373 952  (E.D. PARENT)<br>* Revendications 1,2,5,6; colonne 3, lignes 9-20 * | 1,5,17- 20,22- 24 | |
| Y | | 7 | |
| Y | DE-A-2 000 710  (UNITED STATES BORAX & CHEMICAL CORP.)<br>* Revendication 1; page 1, paragraphe 1; page 3, paragraphe 3 * | 7 | **DOMAINES TECHNIQUES RECHERCHES (Int. Cl.5)**<br><br>C 04 B  35/00<br>C 23 C  14/00 |
| A | | 9 | |

Le présent rapport a été établi pour toutes les revendications

| Lieu de la recherche | Date d'achèvement de la recherche | Examinateur |
|---|---|---|
| LA HAYE | 14-02-1991 | HAUCK, H.N. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
................................................................
& : membre de la même famille, document correspondant

EPO FORM 1503 03.82 (P0402)